# EUROPEAN PATENT APPLICATION

(11) **EP 4 431 954 A1**
(43) Date of publication of application: **18.09.2024**
(21) Application number: 23162074.1
(22) Date of filing: 15.03.2023
(51) Int. Cl.: G01R 31/00

(54) **METHOD FOR PERFORMING EMC IMMUNITY MEASUREMENTS AND VEHICLE EMC IMMUNITY MEASUREMENT SYSTEM**

(71) Applicant: Ningbo Geely Automobile Research & Development Co. Ltd., Hangzhou Bay New District Ningbo 315336 (CN); Zhejiang Geely Holding Group Co., Ltd., Hangzhou, Zhejiang 310051 (CN)
(72) Inventor: MOESTAM, Robert, 352 42 VÄXJÖ (SE)
(74) Representative: Zacco Sweden AB

(57) **Abstract**

The disclosure concerns a method and EMC measurement system for performing EMC measurements of a complete vehicle. The vehicle comprises ADAS sensors connected to and in communication with a vehicle driving control system configured for controlling operation of the vehicle. The ADAS sensors are configured for sending ADAS sensor output signals to the vehicle driving control system. The vehicle EMC measurement system comprises an EMC test chamber, an electromagnetic radiation transmitting/receiving unit, an external output unit, and an EMC measuring unit. Communication cables from the ADAS sensors are disconnected, preventing communication between the ADAS sensors and the vehicle driving control system, and the communication cables are connected to the external output unit, enabling communication between the external output unit and the vehicle driving control system. The vehicle driving control system is activated for operating the vehicle in the EMC test chamber, and synchronized external ADAS sensor output signals are transmitted from the external output unit to the vehicle driving control system via the communication cables. Electromagnetic radiation is transmitted in the EMC test chamber by means of the electromagnetic radiation transmitting/receiving unit for conducting EMC immunity measurements, or electromagnetic radiation from the vehicle in the EMC test chamber is received by means of the electromagnetic radiation transmitting/receiving unit for conducting EMC radiation measurements.

## Description

### TECHNICAL FIELD

The present disclosure relates to a method for performing electromagnetic compatibility (EMC) measurements of a complete vehicle by a vehicle EMC measurement system. The disclosure further relates to a vehicle EMC measurement system, a non-transitory computer-readable medium, and a cloud computing system.

### BACKGROUND

Electromagnetic compatibility (EMC) measurements and testing operations are aiming at ensuring safe operation of vehicles in the electromagnetic environment to which they may be exposed, or alternatively aiming at understanding the electromagnetic radiation emitted from the vehicles. In order to have controlled and repeatable testing conditions, EMC measurements are commonly conducted in a stationary and screened EMC test chamber.

The performance of different vehicle systems, such as systems for autonomous driving vehicles or semi-autonomous driving vehicles, may be impacted by strong electromagnetic inference, and the EMC of the vehicle therefore needs to be measured. Further, vehicle systems may emit electromagnetic radiation to the surroundings, and there is a need to measure the emitted electromagnetic radiation.

It is often difficult to find a suitable outdoor environment to perform the EMC measuring and testing procedures of an autonomous driving vehicle or a semi-autonomous driving vehicle, because the electromagnetic inference in the outdoor environment typically is not strong enough to have a meaningful impact on the software and hardware of the vehicle. Therefore, for the EMC measuring and testing procedures, an indoor EMC testing environment is frequently used, where the electromagnetic inference of a desired level can be artificially established.

There are however, limitations associated with the indoor EMC testing environment. As an example, an autonomous driving vehicle or a semi-autonomous driving vehicle cannot freely move as it does in the outdoor environment. As a result, the autonomous driving system or the semi-autonomous driving system of the vehicle may need to be modified to accommodate the limitations such that the EMC measurements of the vehicle would be conducted as if the vehicle normally was driven in the outdoor environment.

The vehicle is using ADAS sensors when operated. When the vehicle is operated in the EMC test chamber during the EMC measurements, the ADAS sensors cannot detect the surrounding environment in the same way as in real traffic situations, since the vehicle in fact is stationary in the EMC test chamber. The ADAS sensors thus have to be manipulated in order for the vehicle to receive relevant ADAS sensor output signals. In some EMC measurement procedures, large image screens, GPS transmitters, and radar targets are used for proving input to the ADAS sensors. Such arrangements are however costly and complex. Further, the input to the ADAS sensors provided by the image screens, GPS transmitters, and radar targets are often not fully corresponding to real traffic situations.

ADAS systems may detect that the vehicle is stationary and the vehicle may be set into a mode called dyno test mode, which is a mode dedicated for the manufacturers to be able to do certifying tests. The dyno test mode turns off ADAS functionality in order to enable drive simulations in a stationary facility like a vehicle dynamometer, and the dyno test mode makes it impossible to test ADAS functionality without detailed software control over the vehicle drive system, which is difficult to achieve. Further, complete vehicle tests are needed since differences between test setup and vehicle installation differs and may lead to differences to the EMC measurements made.

There is thus a need for improved EMC measuring and testing procedures for vehicles.

### SUMMARY

An object of the present disclosure is to provide a method for performing electromagnetic compatibility (EMC) measurements of a complete vehicle by a vehicle EMC measurement system, a vehicle EMC measurement system, a non-transitory computer-readable medium, and a cloud computing system, where the previously mentioned problems are avoided. This object is at least partly achieved by the features of the independent claims. The dependent claims contain further developments of the method for performing electromagnetic compatibility (EMC) measurements of a complete vehicle by a vehicle EMC measurement system, and the vehicle EMC measurement system.

The disclosure concerns a method for performing EMC measurements of a complete vehicle by a vehicle EMC measurement system. The vehicle comprises ADAS sensors and a vehicle driving control system configured for controlling operation of the vehicle. The ADAS sensors are connected to and in communication with the vehicle driving control system via communication cables and configured for sending ADAS sensor output signals to the vehicle driving control system. The vehicle EMC measurement system comprises an EMC test chamber, an electromagnetic radiation transmitting/receiving unit, an external output unit, and an EMC measuring unit. The method comprises the steps: providing the complete vehicle and positioning the vehicle in the EMC test chamber; disconnecting the communication cables from the ADAS sensors, preventing communication between the ADAS sensors and the vehicle driving control system; connecting the communication cables to the external output unit, enabling communication between the external output unit and the vehicle driving control system; activating the vehicle driving control system for operating the vehicle in the EMC test chamber, and transmitting synchronized external ADAS sensor output signals from the external output unit to the vehicle driving control system via the communication cables; transmitting electromagnetic radiation in the EMC test chamber by means of the electromagnetic radiation transmitting/receiving unit, and conducting EMC immunity measurements of the vehicle by means of the EMC measuring unit upon activation of the vehicle driving control system for operating the vehicle when the synchronized external ADAS sensor output signals are transmitted to the vehicle driving control system from the external output unit, or receiving electromagnetic radiation from the vehicle in the EMC test chamber by means of the electromagnetic radiation transmitting/receiving unit, and conducting EMC radiation measurements of the vehicle by means of the EMC measuring unit upon activation of the vehicle driving control system for operating the vehicle when the synchronized external ADAS sensor output signals are transmitted to the vehicle driving control system from the external output unit.

Advantages with these features are that reliable and efficient EMC measurements for a complete vehicle are enabled with the method. The method may be enabled in two different modes for a high flexibility, where either EMC immunity or EMC radiation is measured. By the method, safe operation of vehicles in the electromagnetic environment to which they may be exposed is ensured, and the electromagnetic radiation emitted from the vehicles can be detected. In order to have controlled and repeatable testing conditions, the vehicle EMC measurement system comprises an EMC test chamber. With the method, the vehicle can be operated in the same way as when driven in the outdoor environment during the EMC measurements. Through the ADAS sensor output signals transmitted to the vehicle driving control system from the external output unit, the vehicle is using ADAS sensor information when operated for accurate EMC measurements. This enables maintained ADAS functionality for reliable EMC measurements. The EMC measurement procedures can be made without costly and complex arrangements including large image screens, GPS transmitters, and radar targets.

In one embodiment, the synchronized external ADAS sensor output signals transmitted from the external output unit are corresponding to ADAS sensor output signals transmitted from the ADAS sensors to the vehicle driving control system upon operating the vehicle in real traffic situations. In this way, the vehicle can be operated in the same way as in real traffic situations for accurate EMC measurements. The vehicle driving control system is thus receiving the same type of signals in the EMC test chamber, as when operating the vehicle in real traffic situations.

In one embodiment, the synchronized external ADAS sensor output signals are recorded synchronized ADAS sensor output signals from real traffic situations, and/or the synchronized external ADAS sensor output signals are simulated synchronized ADAS sensor output signals corresponding to real traffic situations. The synchronized external ADAS sensor output signals can be configured as recorded synchronized ADAS sensor output signals from real traffic situations. A vehicle may thus be operated in real traffic situations and the ADAS sensor output signals are recorded by a recording unit and thereafter used as the synchronized external ADAS sensor output signals during the EMC measurement operation. Alternatively, the synchronized external ADAS sensor output signals are configured as simulated synchronized ADAS sensor output signals corresponding to real traffic situations. Further, the synchronized external ADAS sensor output signals may be configured as a combination of recorded and simulated synchronized ADAS sensor output signals corresponding to real traffic situations.

In one embodiment, the method further comprises the steps: operating the vehicle in an autonomous driving mode or operating the vehicle in a semi-autonomous driving mode, upon activation of the vehicle driving control system. With these operational modes, the vehicle is using the ADAS sensor signals for reliable EMC measurements.

In one embodiment, the external output unit is arranged in a position outside the EMC test chamber. External communication cables connected to the external output unit are extending from the external output unit to the vehicle. The method further comprises the step: connecting the external output unit to the communication cables of the vehicle via the external communication cables for enabling communication between the external output unit and the vehicle driving control system. The position of the external output unit outside the EMC test chamber is allowing test operators to control the EMC measurements efficiently without disturbing the measurements in the EMC test chamber.

In one embodiment, the external communication cables are arranged as fibre optic links. The fibre optic links are efficiently transmitting the external ADAS sensor output signals from the external output unit.

In one embodiment, the EMC test chamber is configured as an electromagnetic reverberation chamber or an electromagnetic anechoing chamber. The EMC test chamber may have any suitable configuration, and the EMC test chamber is suitably arranged as an electromagnetic reverberation chamber or an electromagnetic anechoing chamber. The measurement and test equipment used in the EMC test chamber is adapted to the type of EMC test chamber used. An electromagnetic anechoic chamber is a room designed to stop reflections of electromagnetic waves, and are commonly isolated from energy entering from the surroundings. An electromagnetic reverberation chamber is an environment for EMC measurements arranged as a screened room with a minimum of absorption of electromagnetic energy.

In one embodiment, the steps of: activating the vehicle driving control system, and transmitting synchronized external ADAS sensor output signals from the external output unit to the vehicle driving control system via the communication cables; and transmitting electromagnetic radiation in the EMC test chamber by means of the electromagnetic radiation transmitting/receiving unit, and conducting EMC immunity measurements of the vehicle by means of the EMC measuring unit upon activation of the vehicle driving control system for operating the vehicle when the synchronized external ADAS sensor output signals are transmitted to the vehicle driving control system from the external output unit; are computer implemented. In an alternative embodiment, the steps of: activating the vehicle driving control system, and transmitting synchronized external ADAS sensor output signals from the external output unit to the vehicle driving control system via the communication cables; and receiving electromagnetic radiation from the vehicle in the EMC test chamber by means of the electromagnetic radiation transmitting/receiving unit, and conducting EMC radiation measurements of the vehicle by means of the EMC measuring unit upon activation of the vehicle driving control system for operating the vehicle when the synchronized external ADAS sensor output signals are transmitted to the vehicle driving control system from the external output unit; are computer implemented.

The disclosure further concerns a vehicle EMC measurement system comprising an EMC test chamber, an electromagnetic radiation transmitting/receiving unit, an external output unit, and an EMC measuring unit. The vehicle EMC measurement system is arranged for measuring EMC of a complete vehicle positioned in the EMC test chamber. The vehicle comprises ADAS sensors and a vehicle driving control system configured for controlling operation of the vehicle. The ADAS sensors are connected to and in communication with the vehicle driving control system via communication cables and configured for sending ADAS sensor output signals to the vehicle driving control system. The external output unit is configured for being connected to the vehicle driving control system via the communication cables, enabling communication between the external output unit and the vehicle driving control system, when the communication cables are disconnected from the ADAS sensors, preventing communication between the ADAS sensors and the vehicle driving control system. The external output unit is configured for transmitting synchronized external ADAS sensor output signals to the vehicle driving control system via the communication cables upon activation of the vehicle driving control system for operating the vehicle in the EMC test chamber. The electromagnetic radiation transmitting/receiving unit is configured for transmitting electromagnetic radiation in the EMC test chamber, and the EMC measuring unit is configured for conducting EMC immunity measurements of the vehicle upon activation of the vehicle driving control system for operating the vehicle when the synchronized external ADAS sensor output signals are transmitted to the vehicle driving control system from the external output unit; or the electromagnetic radiation transmitting/receiving unit is configured for receiving electromagnetic radiation from the vehicle in the EMC test chamber, and the EMC measuring unit is configured for conducting EMC radiation measurements of the vehicle upon activation of the vehicle driving control system for operating the vehicle when the synchronized external ADAS sensor output signals are transmitted to the vehicle driving control system from the external output unit.

Advantages with these features are that reliable and efficient EMC measurements for a complete vehicle are enabled with the system. The system may be operated in two different modes for a high flexibility, where either EMC immunity or EMC radiation is measured. With the system, safe operation of vehicles in the electromagnetic environment to which they may be exposed is ensured, and the electromagnetic radiation emitted from the vehicles can be detected. In order to have controlled and repeatable testing conditions, the vehicle EMC measurement system comprises an EMC test chamber. With the system, the vehicle can be operated in the same way as when driven in the outdoor environment during the EMC measurements. Through the ADAS sensor output signals transmitted to the vehicle driving control system from the external output unit, the vehicle is using ADAS sensor information when operated for accurate EMC measurements, which enables maintained ADAS functionality for reliable EMC measurements. The EMC measurement procedures can be made without costly and complex arrangements including large image screens, GPS transmitters, and radar targets.

In one embodiment, the synchronized external ADAS sensor output signals transmitted from the external output unit are corresponding to ADAS sensor output signals transmitted from the ADAS sensors to the vehicle driving control system upon operating the vehicle in real traffic situations. In this way, the vehicle can be operated in the same way as in real traffic situations for accurate EMC measurements. The vehicle driving control system is thus receiving the same type of signals in the EMC test chamber, as when operating the vehicle in real traffic situations.

In one embodiment, the synchronized external ADAS sensor output signals are recorded synchronized ADAS sensor output signals from real traffic situations, and/or the synchronized external ADAS sensor output signals are simulated synchronized ADAS sensor output signals corresponding to real traffic situations. The synchronized external ADAS sensor output signals can be configured as recorded synchronized ADAS sensor output signals from real traffic situations. A vehicle may thus be operated in real traffic situations and the ADAS sensor output signals are recorded by a recording unit and thereafter used as the synchronized external ADAS sensor output signals during the EMC measurement operation. Alternatively, the synchronized external ADAS sensor output signals are configured as simulated synchronized ADAS sensor output signals corresponding to real traffic situations. Further, the synchronized external ADAS sensor output signals may be configured as a combination of recorded and simulated synchronized ADAS sensor output signals corresponding to real traffic situations.

In one embodiment, the vehicle is operated in an autonomous driving mode or in a semi-autonomous driving mode, upon activation of the vehicle driving control system. With these operational modes, the vehicle is using the ADAS sensor signals for reliable EMC measurements.

In one embodiment, the external output unit is arranged in a position outside the EMC test chamber. External communication cables connected to the external output unit are extending from the external output unit to the vehicle. The external output unit is connected to the communication cables of the vehicle via the external communication cables, enabling communication between the external output unit and the vehicle driving control system. The position of the external output unit outside the EMC test chamber is allowing test operators to control the EMC measurements efficiently without disturbing the measurements in the EMC test chamber.

In one embodiment, the external communication cables are arranged as fibre optic links. The fibre optic links are efficiently transmitting the external ADAS sensor output signals from the external output unit.

In one embodiment, the EMC test chamber is configured as an electromagnetic reverberation chamber or an electromagnetic anechoing chamber. The EMC test chamber may have any suitable configuration, and the EMC test chamber is suitably arranged as an electromagnetic reverberation chamber or an electromagnetic anechoing chamber. The measurement and test equipment used in the EMC test chamber is adapted to the type of EMC test chamber used. An electromagnetic anechoic chamber is a room designed to stop reflections of electromagnetic waves, and are commonly isolated from energy entering from the surroundings. An electromagnetic reverberation chamber is an environment for EMC measurements arranged as a screened room with a minimum of absorption of electromagnetic energy.

In one embodiment, the electromagnetic radiation transmitting/receiving unit comprises one or more antennas arranged in the EMC test chamber, wherein the one or more antennas are configured for transmitting and/or receiving electromagnetic radiation in the EMC test chamber.

The disclosure further concerns a non-transitory computer-readable medium comprising instructions which, when executed by a computer, cause the computer to carry out the method.

The disclosure further concerns a cloud computing system configured to carry out the method.

### BRIEF DESCRIPTION OF DRAWINGS

The disclosure will be described in detail in the following, with reference to the attached drawings, in which
- Fig. 1: shows schematically, in a perspective view, a vehicle EMC measurement system with a complete vehicle positioned in an EMC test chamber, according to the disclosure,
- Fig. 2a-b: show schematically, in side views, the complete vehicle with a vehicle driving control system connected to ADAS sensors, and the complete vehicle with the vehicle driving control system disconnected from the ADAS sensors and connected to an external output unit, according to the disclosure,
- Fig. 3a-c: shows schematically, in operational views, the vehicle driving control system connected to the ADAS sensors, the vehicle driving control system disconnected from the ADAS sensors, and the vehicle driving control system connected to the external output unit.

### DESCRIPTION OF EXAMPLE EMBODIMENTS

Various aspects of the disclosure will hereinafter be described in conjunction with the appended drawings to illustrate and not to limit the disclosure, wherein like designations denote like elements, and variations of the described aspects are not restricted to the specifically shown embodiments, but are applicable on other variations of the disclosure.

Those skilled in the art will appreciate that steps, services and functions explained herein may be implemented using individual hardware circuitry, using software functioning in conjunction with a programmed microprocessor or general purpose computer, using one or more Application Specific Integrated Circuits (ASICs) and/or using one or more Digital Signal Processors (DSPs). It will also be appreciated that when the present disclosure is described in terms of a method, it may also be embodied in one or more processors and one or more memories coupled to the one or more processors, wherein the one or more memories store one or more programs that perform the steps, services and functions disclosed herein when executed by the one or more processors.

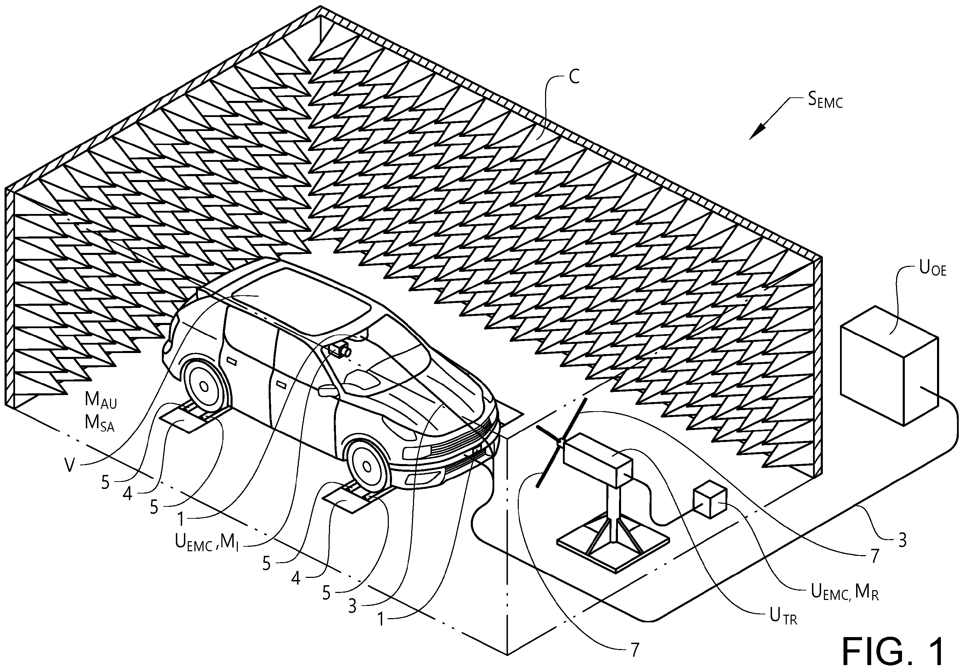

Figure 1 schematically shows an electromagnetic compatibility (EMC) measurement system S_{EMC}. The EMC measurement system S_{EMC} is used for performing EMC measurement and testing operations of a complete vehicle V. The vehicle EMC measurement system S_{EMC} comprises an EMC test chamber C, an electromagnetic radiation transmitting/receiving unit U_{TR}, an external output unit U_{OE}, and an EMC measuring unit U_{EMC}. The complete vehicle V is as understood from the figure arranged in the EMC test chamber C.

EMC measurements and testing operations are aiming at ensuring safe operation of vehicles in the electromagnetic environment to which they may be exposed, or alternatively aiming at understanding the electromagnetic radiation emitted from the vehicles. In order to have controlled and repeatable testing conditions, EMC measurements are commonly conducted in a stationary and screened EMC test chamber.

The performance of different vehicle systems may be impacted by strong electromagnetic inference, and the EMC of the vehicle therefore needs to be measured. EMC is the ability of electrical equipment and systems to function acceptably in their electromagnetic environment, and there is a need for measuring the functionality of individual vehicle components as well as the complete vehicle to secure reliable operation of the vehicle in operating conditions of the vehicle. To comply with government regulations and legal requirements, and to ensure the safety of the vehicle, the vehicle needs to go through EMC measurement procedures. It is in the EMC measuring procedures measured and tested how software and hardware in the vehicle are impacted in an EMC testing environment. The EMC testing environment is established in the EMC test chamber C.

The EMC testing procedure is used for determining if actions related to limiting unintentional generation, propagation and reception of electromagnetic energy that may cause unwanted effects, such as electromagnetic interference, or even damage in operational equipment is needed. The goal of the EMC testing procedure is to determine the correct operation of different equipment in a common electromagnetic environment.

Vehicles operating in an autonomous driving mode or a semi-autonomous driving mode can relieve a driver of the vehicle from certain driving-related responsibilities. When operating in the autonomous driving mode or the semi-autonomous driving mode, the vehicle is using autonomous drive functions, and sensors arranged on the vehicle allow the vehicle to travel with less human interaction.

Autonomous driving vehicles and semi-autonomous driving vehicles use autonomous driving systems to drive the vehicle, and the autonomous driving system can include software and hardware. Such a system related to the driving of the vehicles are commonly named advanced driver-assistance system (ADAS). ADAS is using groups of automated technology and electronic equipment that assist drivers in driving the vehicle, and as an example, the system uses ADAS sensors to detect the surrounding environment. By the ADAS sensors, the system may detect nearby obstacles or driver errors and responds accordingly. ADAS can enable various levels of autonomous driving, depending on the type of systems installed in the vehicle. ADAS sensors may have different configurations, such as optical image sensors, sonar sensors, radar sensors, LIDAR sensors and GPS/GNSS sensors. Optical image sensors may be arranged as camera or video sensors. Sonar is referring to sound navigation and ranging, and sonar sensors may be arranged as ultrasonic sensors. Radar is referring to radio detection and ranging, and radar sensors are using specific radio frequencies to detect objects. LIDAR is referring to light detection and ranging, and LIDAR sensors use lasers as energy source. GNSS is a global navigation satellite system used for vehicle navigation. GPS stands for global positioning system and is a GNSS that uses satellites for navigating purposes. It should be understood that ADAS sensors could have other configurations than the ones described above, for example ADAS sensors arranged for communication between vehicles and/or communication between vehicles and surrounding infrastructure, such as V2X (DSRC) and/or C-V2X (4G/5G).

It is often difficult to find a suitable outdoor environment to perform the EMC measuring and testing procedures of an autonomous driving vehicle or a semi-autonomous driving vehicle, because the electromagnetic inference in the outdoor environment typically is not strong enough to have a meaningful impact on the software and hardware of the vehicle. Therefore, for the EMC measuring and testing procedures, the vehicle EMC measurement system S_{EMC} is used, where the electromagnetic inference of a desired level can be artificially established or detected.

The EMC test chamber C may have any suitable configuration, and the EMC test chamber C is commonly arranged as an electromagnetic reverberation chamber or an electromagnetic anechoing chamber. The measurement and test equipment used in the EMC test chamber C is adapted to the type of EMC test chamber C used. In figure 1, the EMC test chamber C is configured as an electromagnetic anechoing chamber for illustrative purposes.

An electromagnetic anechoic chamber is a room designed to stop reflections of electromagnetic waves, and are commonly isolated from energy entering from the surroundings. An electromagnetic reverberation chamber is an environment for EMC measurements arranged as a screened room with a minimum of absorption of electromagnetic energy. These general types of EMC test chambers are known in the art and will not be described more in detail. It should however be understood that the EMC test chamber C may have other suitable designs and configurations.

The vehicle EMC measurement system S_{EMC} is arranged for measuring EMC of a complete vehicle V positioned in the EMC test chamber C. With the expression complete vehicle is meant a vehicle equipped with relevant components and systems, such as a vehicle approved for being operated in normal traffic conditions. The complete vehicle V is thus an assembled vehicle, and not individual vehicle components or vehicle systems. In this context when it is referred to a vehicle, the expression vehicle should be interpreted as a complete vehicle.

The vehicle EMC measurement system S_{EMC} may be operated in different modes, depending on the measurements conducted. In an EMC immunity mode M_{I}, EMC immunity measurements of the vehicle V are conducted in order to determine safe operation of the vehicle V in the electromagnetic environment to which the vehicle V may be exposed. In an EMC radiation mode M_{R}, EMC radiation measurements are conducted in order to determine the electromagnetic radiation emitted from the vehicle V.

In the EMC immunity mode M_{I}, the electromagnetic radiation transmitting/receiving unit U_{TR} is arranged inside the EMC test chamber C, as shown in figure 1. The electromagnetic radiation transmitting/receiving unit U_{TR} is used for transmitting electromagnetic radiation into the EMC test chamber C when the vehicle EMC measurement system S_{EMC} is operated in the EMC immunity mode M_{I}. The electromagnetic radiation transmitting/receiving unit U_{TR} suitably comprises one or more antennas 7 arranged in the EMC test chamber C. The one or more antennas 7 are used for transmitting the electromagnetic radiation in the EMC test chamber C.

In the EMC radiation mode M_{R}, the electromagnetic radiation transmitting/receiving unit U_{TR} is arranged inside the EMC test chamber C, as shown in figure 1. The electromagnetic radiation transmitting/receiving unit U_{TR} is used for receiving electromagnetic radiation emitted by the vehicle V into the EMC test chamber C when the vehicle EMC measurement system S_{EMC} is operated in the EMC radiation mode M_{R}. The electromagnetic radiation transmitting/receiving unit U_{TR} suitably comprises one or more antennas 7 arranged in the EMC test chamber C. The one or more antennas 7 are used for receiving electromagnetic radiation in the EMC test chamber C emitted by the vehicle V. It should be understood that the one or more antennas 7 used for receiving electromagnetic radiation in the EMC test chamber C emitted by the vehicle V may be different from the one or more antennas 7 used for transmitting the electromagnetic radiation in the EMC test chamber C in the ECM immunity measurements.

The external output unit Uoε is arranged in a position outside the EMC test chamber C, as shown in figure 1. The external output unit U_{OE} is suitably arranged as a computer system that is used for providing signals to the vehicle V during the EMC measurement operation. External communication cables 3 are connected to the external output unit U_{OE}, and as understood from the figure, the external communication cables 3 are extending from the external output unit U_{OE} to the vehicle V. The external communication cables 3 are suitable arranged as a cable bundle arranged for being attached to different ADAS sensor connectors of the vehicle V. Suitably, the external communication cables 3 are arranged as fibre optic links.

The EMC measuring unit U_{EMC} may be configured in different ways depending on the measurements made, and depending on the operating mode of the vehicle EMC measurement system SEMC.

In the EMC immunity mode M_{I}, the EMC measuring unit U_{EMC} suitably is arranged as one or more sensors for determining if different vehicle systems are impacted by strong electromagnetic inference. In one embodiment, the EMC measuring unit U_{EMC} is configured as a camera sensor arranged in the vehicle V, as schematically illustrated in figure 1, and the camera sensor is used for determining if the vehicle systems are functioning when the electromagnetic radiation transmitting/receiving unit U_{TR} is transmitting electromagnetic radiation into the EMC test chamber C. The camera sensor may be externally monitored or observed by test persons outside the EMC test chamber C, and by monitoring or observing different vehicle systems, it may be determined if the vehicle systems are operating as they should. In one standard procedure, the wipers and the position lights of the vehicle V are operated and during the operations, different vehicle systems, such as dashboard indicators, vehicle screens and other equipment, are observed by test persons via the camera sensor. In other embodiments, the EMC measuring unit U_{EMC} is configured as one or more sensors arranged in the vehicle for determining the functionality of different vehicle systems, such as sensors connected to different vehicle systems or equipment.

In the EMC radiation mode M_{R}, the EMC measuring unit U_{EMC} suitably is arranged as a measuring unit operating together with the electromagnetic radiation transmitting/receiving unit U_{TR} for detecting the level of electromagnetic radiation emitted from the vehicle V during the EMC measuring operation. In one embodiment, the EMC measuring unit U_{EMC} is connected to the one or more antennas 7 arranged in the EMC test chamber C.

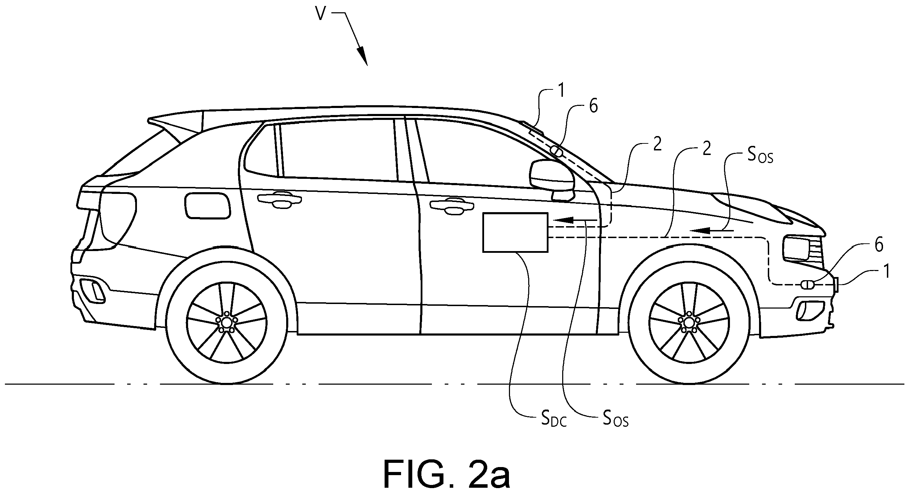

The vehicle V comprises ADAS sensors 1 and a vehicle driving control system S_{DC} configured for controlling operation of the vehicle V, as shown in figures 2a-b. The ADAS sensors 1 are connected to and in communication with the vehicle driving control system S_{DC} via communication cables 2 and configured for sending ADAS sensor output signals Sos to the vehicle driving control system S_{DC}. During normal operation of the vehicle V, such as when operating the vehicle V in real traffic situations, the ADAS sensors 1 are sending relevant information to the vehicle V by the ADAS sensor output signals S_{OS}. The ADAS sensor output signals S_{OS} are thus representing information about the surrounding environment, which information is used by the vehicle driving control system S_{DC} when operating the vehicle V. Vehicles commonly have a plurality of ADAS sensors used for detecting the surrounding environment. In the embodiment shown in the figures, the vehicle V comprises two ADAS sensors for illustrative purposes. It should however be understood that the vehicle V may be equipped with, any suitable number of ADAS sensors 1.

The vehicle driving control system S_{DC} may have different configurations depending on the type of vehicle V. In one embodiment, the vehicle V is operated in an autonomous driving mode M_{AU} by the vehicle driving control system S_{DC} when activated. In one embodiment, the vehicle V is operated in a semi-autonomous driving mode M_{SA} with support from the vehicle driving control system S_{DC} when activated.

There are limitations associated with the indoor EMC testing environment, since the vehicle V cannot freely move as it does in the outdoor environment. Therefore, the driving operation of the vehicle V needs to be efficiently controlled. As shown in figure 1, the EMC test chamber C further comprises a vehicle dynamometer system 4 in connection to front wheels and rear wheels of the vehicle V. The vehicle dynamometer system 4 comprises rollers 5 onto which the vehicle V is positioned. The rollers 5 are emulating vehicle inertia and vehicle road load that the vehicle experiences on a real road. By using the vehicle dynamometer system 4, the vehicle V can be operated in the EMC test chamber C in a way similar to operation in real traffic situations, such as in the autonomous driving mode M_{AU} by the vehicle driving control system S_{DC} or in the semi-autonomous driving mode M_{SA} with support from the vehicle driving control system S_{DC}. As a result, EMC measurements of the vehicle can be conducted as if the vehicle normally was driven in the outdoor environment, as will be further described below. The vehicle dynamometer system 4 may have any suitable configuration, and such systems are well known in the art and are further not described herein.

In the EMC test chamber C, the vehicle V may be controlled from outside the EMC test chamber C for operating the vehicle V in the autonomous driving mode M_{AU} by the vehicle driving control system S_{DC} or in the semi-autonomous driving mode M_{SA} with support from the vehicle driving control system S_{DC}. Thus, the vehicle V may be connected to a non-illustrated control unit or similar device for supporting the operation of the vehicle in the EMC test chamber C in the autonomous driving mode M_{AU} and in the semi-autonomous driving mode M_{SA}. The vehicle V may further be equipped with suitable control arrangements for supporting the operation of the vehicle in the EMC test chamber C in the autonomous driving mode M_{AU} or in the semi-autonomous driving mode M_{SA}, enabling operation without test persons seated in the vehicle V.

When the vehicle is operated in the EMC test chamber C, the ADAS sensors 1 cannot detect the surrounding environment in the same way as in real traffic situations, since the vehicle V in fact is stationary in the EMC test chamber C. According the disclosure, the external output unit Uoε instead of the ADAS sensors 1 arranged on the vehicle V is used for providing ADAS sensor output signals to the vehicle driving control system S_{DC}. The ADAS sensors 1 are connected to and in communication with the vehicle driving control system S_{DC} via communication cables 2, as shown in figure 2a. The ADAS sensors 1 need to be disconnected from the vehicle driving control system S_{DC} for enabling the external output unit U_{OE} to send synchronized external ADAS sensor output signals S_{OSE} to the vehicle driving control system S_{DC}. The communication cables 2 are suitable arranged as a cable bundle arranged for connecting the vehicle driving control system S_{DC} to different ADAS sensors 1 and possibly other components of the vehicle V. The communication cables 2 are suitably arranged as fibre optic links.

The external output unit U_{OE} is configured for being connected to the vehicle driving control system S_{DC} via the communication cables 2. The external output unit U_{OE} is connected to the communication cables 2 of the vehicle V via the external communication cables 3, enabling communication between the external output unit U_{OE} and the vehicle driving control system S_{DC}. As described above, the external communication cables 3 are extending from the external output unit U_{OE} to the vehicle V.

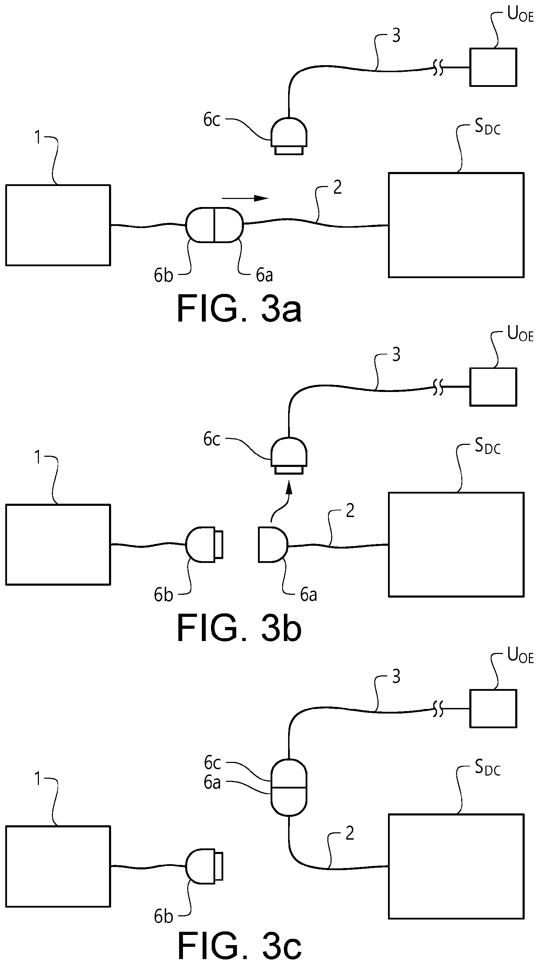

To connect the external output unit U_{OE} to the vehicle V, the communication cables 2 extending from the vehicle driving control system S_{DC} to the ADAS sensors 1 need to be disconnected from the ADAS sensors 1. In figures 2a and 3a, the connection between the vehicle driving control system S_{DC} and one of the ADAS sensors 1 via the communication cables 2 are schematically illustrated. As shown in the figures, the communication cables 2 are connected to the ADAS sensors via connectors 6. The connectors 6 comprises first connector parts 6a attached to the communication cables 2 and second connector parts 6b attached to the ADAS sensors 1.

By disconnecting the first connector parts 6a from the second connector parts 6b, the communication cables 2 are disconnected from the ADAS sensors 1. When the communication cables 2 are disconnected from the ADAS sensors 1 communication between the ADAS sensors 1 and the vehicle driving control system S_{DC} is prevented, as shown in figure 3b.

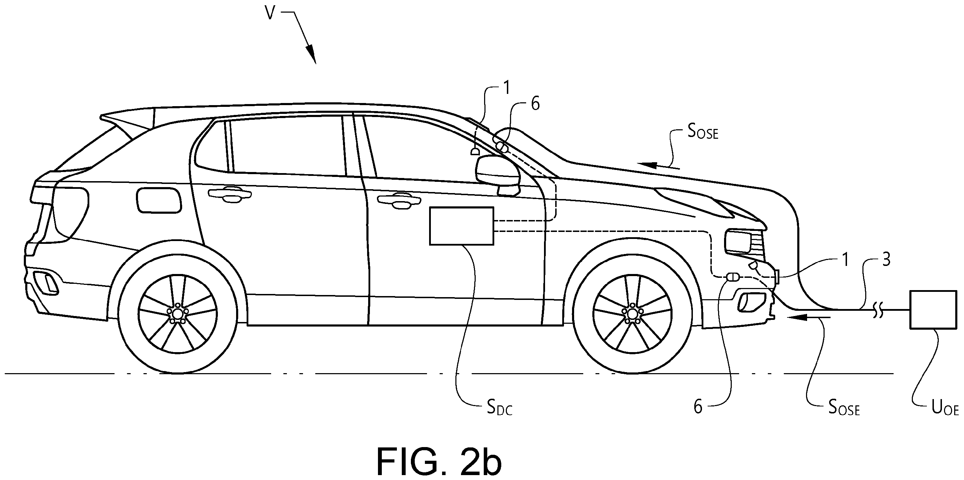

The external communication cables 3 comprises third connector parts 6c configured as corresponding second connector parts 6b, and the third connector parts 6c are configured for being connected to corresponding first connector parts 6a. By connecting the third connector parts 6c to corresponding first connector parts 6a communication between the external output unit Uoε and the vehicle driving control system S_{DC} via the external communication cables 3 and the communication cables 2 is enabled, as shown in figures 2b and 3c. Thus, when the communication cables 2 have been disconnected from the ADAS sensors 1, and instead have been connected to the external output unit Uoε, communication between the ADAS sensors 1 and the vehicle driving control system S_{DC} is prevented and instead communication between the external output unit Uoε and the vehicle driving control system S_{DC} is enabled.

It should be understood that the connector parts could have different configurations for different ADAS sensors 1.

The external output unit U_{OE} is configured for transmitting the synchronized external ADAS sensor output signals S_{OSE} to the vehicle driving control system S_{DC} via the external communication cables 3 and the communication cables 2 upon activation of the vehicle driving control system S_{DC} for operating the vehicle V in the EMC test chamber C during the EMC measuring operation. When operating the vehicle V in the EMC test chamber C during the EMC measuring operation, the vehicle V is driven in the EMC test chamber C on the vehicle dynamometer system 4, in a way similar to operation in real traffic situations. Instead of detecting the surrounding environment by means of the ADAS sensors 1, the synchronized external ADAS sensor output signals Sosε transmitted to the vehicle driving control system S_{DC} from the external output unit Uoε are used for imitating the output from the disconnected ADAS sensors 1. The synchronized external ADAS sensor output signals S_{OSE} transmitted from the external output unit U_{OE} are thus corresponding to ADAS sensor output signals S_{OS} transmitted from the ADAS sensors 1 to the vehicle driving control system S_{DC} upon operating the vehicle V in real traffic situations. By the expression synchronized external ADAS sensor output signals Sosε is meant a set of signals sent from the external output unit U_{OE} to the vehicle driving control system S_{DC} corresponding to combined ADAS sensor output signals Sos from one or more ADAS sensors 1 transmitted to the vehicle driving control system S_{DC} during operation of the vehicle V in real traffic situations.

The synchronized external ADAS sensor output signals S_{OSE} are suitably configured as recorded synchronized ADAS sensor output signals S_{OS} from real traffic situations. A vehicle may thus be operated in real traffic situations and the ADAS sensor output signals Sos are recorded by a recording unit and thereafter used as the synchronized external ADAS sensor output signals Sosε during the EMC measurement operation. Alternatively, the synchronized external ADAS sensor output signals S_{OSE} are configured as simulated synchronized ADAS sensor output signals S_{OS} corresponding to real traffic situations, or configured as a combination of recorded and simulated synchronized ADAS sensor output signals S_{OS} corresponding to real traffic situations. In the EMC immunity mode M_{I}, the electromagnetic radiation transmitting/receiving unit U_{TR} is used for transmitting electromagnetic radiation into the EMC test chamber C during the vehicle EMC measurement operation.

Further, in the EMC immunity mode M_{I}, the EMC measuring unit U_{EMC} is conducting EMC immunity measurements of the vehicle V upon activation of the vehicle driving control system S_{DC} for operating the vehicle V when the synchronized external ADAS sensor output signals S_{OSE} are transmitted to the vehicle driving control system S_{DC} from the external output unit Uoε.

To perform immunity EMC measurements of the complete vehicle V by the vehicle EMC measurement system S_{EMC} in the EMC immunity mode M_{I}, the vehicle V is positioned in the EMC test chamber C with the wheels onto the rollers 5 of the vehicle dynamometer system 4, as understood from figure 1. The communication cables 2 connecting the ADAS sensors 1 to the vehicle driving control system S_{DC}, are disconnected from the ADAS sensors 1 for preventing communication between the ADAS sensors 1 and the vehicle driving control system S_{DC}. Thereafter, the communication cables 2 are connected to the external output unit U_{OE}, enabling communication between the external output unit U_{OE} and the vehicle driving control system S_{DC}, as described above in connection to figures 3a-c. When the external output unit U_{OE} and the vehicle driving control system S_{DC} are connected to each other via the external communication cables 3 and the communication cables 2, the vehicle driving control system S_{DC} is activated for operating the vehicle V in the EMC test chamber C. Upon activation of the vehicle driving control system S_{DC}, the synchronized external ADAS sensor output signals Sosε are transmitted from the external output unit Uoε to the vehicle driving control system S_{DC} via the external communication cables 3 and the communication cables 2. When transmitting the synchronized external ADAS sensor output signals S_{OSE}, the vehicle driving control system S_{DC} is receiving information signals corresponding to ADAS sensor output signals S_{OS} transmitted from the ADAS sensors 1 to the vehicle driving control system S_{DC} upon operating the vehicle V in real traffic situations. Electromagnetic radiation is transmitted in the EMC test chamber C by means of the electromagnetic radiation transmitting/receiving unit U_{TR}, and the one or more antennas 7 arranged in the EMC test chamber are sending out the electromagnetic radiation. When the electromagnetic radiation is transmitted in the EMC test chamber C by means of the electromagnetic radiation transmitting/receiving unit U_{TR}, EMC immunity measurements of the vehicle V are conducted by means of the EMC measuring unit U_{EMC} upon activation of the vehicle driving control system S_{DC} for operating the vehicle V when the synchronized external ADAS sensor output signals S_{OSE} are transmitted to the vehicle driving control system S_{DC} from the external output unit U_{OE}. The vehicle V is suitably operated in an autonomous driving mode M_{AU} or in a semi-autonomous driving mode M_{SA}, upon activation of the vehicle driving control system S_{DC}. Further, the EMC test chamber C is suitably configured as an electromagnetic reverberation chamber or an electromagnetic anechoing chamber.

In the EMC immunity mode M_{I}, the steps of: activating the vehicle driving control system S_{DC}, and transmitting synchronized external ADAS sensor output signals S_{OSE} from the external output unit Uoε to the vehicle driving control system S_{DC} via the communication cables 2; and transmitting electromagnetic radiation in the EMC test chamber C by means of the electromagnetic radiation transmitting/receiving unit U_{TR}, and conducting EMC immunity measurements of the vehicle V by means of the EMC measuring unit U_{EMC} upon activation of the vehicle driving control system S_{DC} for operating the vehicle V when the synchronized external ADAS sensor output signals S_{OSE} are transmitted to the vehicle driving control system S_{DC} from the external output unit U_{OE}; are suitably computer implemented.

In the EMC radiation mode M_{R}, the electromagnetic radiation transmitting/receiving unit U_{TR} is used for receiving electromagnetic radiation emitted by the vehicle V into the EMC test chamber C during the vehicle EMC measurement operation.

Further, in the EMC radiation mode M_{R}, the EMC measuring unit U_{EMC} is conducting EMC radiation measurements of the vehicle V upon activation of the vehicle driving control system S_{DC} for operating the vehicle V when the synchronized external ADAS sensor output signals S_{OSE} are transmitted to the vehicle driving control system S_{DC} from the external output unit U_{OE}.

To perform radiation EMC measurements of the complete vehicle V by the vehicle EMC measurement system S_{EMC} in the EMC radiation mode M_{R}, the vehicle V is positioned in the EMC test chamber C with the wheels onto the rollers 5 of the vehicle dynamometer system 4, as understood from figure 1. The communication cables 2 connecting the ADAS sensors 1 to the vehicle driving control system S_{DC} are disconnected from the ADAS sensors 1 for preventing communication between the ADAS sensors 1 and the vehicle driving control system S_{DC}. Thereafter, the communication cables 2 are connected to the external output unit U_{OE}, enabling communication between the external output unit U_{OE} and the vehicle driving control system S_{DC}, as described above in connection to figures 3a-c. When the external output unit U_{OE} and the vehicle driving control system S_{DC} are connected to each other via the external communication cables 3 and the communication cables 2, the vehicle driving control system S_{DC} is activated for operating the vehicle V in the EMC test chamber C. Upon activation of the vehicle driving control system S_{DC}, the synchronized external ADAS sensor output signals S_{OSE} are transmitted from the external output unit U_{OE} to the vehicle driving control system S_{DC} via the external communication cables 3 and the communication cables 2. When transmitting the synchronized external ADAS sensor output signals S_{OSE}, the vehicle driving control system S_{DC} is receiving information signals corresponding to ADAS sensor output signals Sos transmitted from the ADAS sensors 1 to the vehicle driving control system S_{DC} upon operating the vehicle V in real traffic situations. Electromagnetic radiation from the vehicle V in the EMC test chamber C is received by means of the electromagnetic radiation transmitting/receiving unit U_{TR}, and the one or more antennas 7 arranged in the EMC test chamber are receiving the electromagnetic radiation emitted by the vehicle V. When the electromagnetic radiation emitted from the vehicle V is received in the EMC test chamber C by means of the electromagnetic radiation transmitting/receiving unit U_{TR}, EMC radiation measurements of the vehicle V are conducted by means of the EMC measuring unit U_{EMC} upon activation of the vehicle driving control system S_{DC} for operating the vehicle V when the synchronized external ADAS sensor output signals Sosε are transmitted to the vehicle driving control system S_{DC} from the external output unit Uoε. The vehicle V is suitably operated in an autonomous driving mode M_{AU} or in a semi-autonomous driving mode M_{SA}, upon activation of the vehicle driving control system S_{DC}. Further, the EMC test chamber C is suitably configured as an electromagnetic reverberation chamber or an electromagnetic anechoing chamber.

In the EMC radiation mode M_{R}, the steps of: activating the vehicle driving control system S_{DC}, and transmitting synchronized external ADAS sensor output signals Sosε from the external output unit Uoε to the vehicle driving control system S_{DC} via the communication cables 2; and receiving electromagnetic radiation from the vehicle V in the EMC test chamber C by means of the electromagnetic radiation transmitting/receiving unit U_{TR}, and conducting EMC radiation measurements of the vehicle V by means of the EMC measuring unit U_{EMC} upon activation of the vehicle driving control system S_{DC} for operating the vehicle V when the synchronized external ADAS sensor output signals Sosε are transmitted to the vehicle driving control system S_{DC} from the external output unit Uoε; are suitably computer implemented.

The present disclosure has been presented above with reference to specific embodiments. However, other embodiments than the above described are possible and within the scope of the disclosure. Different method steps than those described above, performing the method by hardware or software, may be provided within the scope of the disclosure. Thus, according to an exemplary embodiment, there is provided a non-transitory computer-readable storage medium storing one or more programs configured to be executed by one or more processors of the vehicle EMC measurement system S_{EMC}, the one or more programs comprising instructions for performing the method according to any one of the above-discussed embodiments. Alternatively, according to another exemplary embodiment a cloud computing system can be configured to perform any of the method aspects presented herein. The cloud computing system may comprise distributed cloud computing resources that jointly perform the method aspects presented herein under control of one or more computer program products. Moreover, the processor may be connected to one or more communication interfaces and/or sensor interfaces for receiving and/transmitting data with external entities such as e.g. sensors arranged on the vehicle surface, an off-site server, or a cloud-based server.

The processor or processors associated with the vehicle EMC measurement system S_{EMC} may be or include any number of hardware components for conducting data or signal processing or for executing computer code stored in memory. The system may have an associated memory, and the memory may be one or more devices for storing data and/or computer code for completing or facilitating the various methods described in the present description. The memory may include volatile memory or non-volatile memory. The memory may include database components, object code components, script components, or any other type of information structure for supporting the various activities of the present description. According to an exemplary embodiment, any distributed or local memory device may be utilized with the systems and methods of this description. According to an exemplary embodiment the memory is communicably connected to the processor (e.g., via a circuit or any other wired, wireless, or network connection) and includes computer code for executing one or more processes described herein.

It will be appreciated that the above description is merely exemplary in nature and is not intended to limit the present disclosure, its application or uses. While specific examples have been described in the specification and illustrated in the drawings, it will be understood by those of ordinary skill in the art that various changes may be made and equivalents may be substituted for elements thereof without departing from the scope of the present disclosure as defined in the claims. Furthermore, modifications may be made to adapt a particular situation or material to the teachings of the present disclosure without departing from the essential scope thereof. Therefore, it is intended that the present disclosure not be limited to the particular examples illustrated by the drawings and described in the specification as the best mode presently contemplated for carrying out the teachings of the present disclosure, but that the scope of the present disclosure will include any embodiments falling within the foregoing description and the appended claims. Reference signs mentioned in the claims should not be seen as limiting the extent of the matter protected by the claims, and their sole function is to make claims easier to understand.

### REFERENCE SIGNS

- 1:: ADAS sensors
- 2:: Communication cables
- 3:: External communication cables
- 4:: Vehicle dynamometer system
- 5:: Rollers
- 6:: Connector
- 6a:: First connector parts
- 6b:: Second connector parts
- 6c:: Third connector parts
- 7:: Antenna

- C:: EMC test chamber
- M_{AU}:: Autonomous driving mode
- M_{I}:: EMC immunity mode
- M_{R}:: EMC radiation mode
- M_{SA}:: Semi-autonomous driving mode
- S_{DC}:: Vehicle driving control system
- S_{EMC}:: Vehicle EMC measurement system
- S_{OS}:: ADAS sensor output signals
- S_{OSE}:: External ADAS sensor output signals
- U_{EMC}:: EMC measuring unit
- U_{OE}:: External output unit
- U_{TR}:: Electromagnetic radiation transmitting/receiving unit
- V:: Vehicle

## Claims

1. A method for performing EMC measurements of a complete vehicle (V) by a vehicle EMC measurement system (S_{EMC}),
wherein the vehicle (V) comprises ADAS sensors (1) and a vehicle driving control system (S_{DC}) configured for controlling operation of the vehicle (V), wherein the ADAS sensors (1) are connected to and in communication with the vehicle driving control system (S_{DC}) via communication cables (2) and configured for sending ADAS sensor output signals (Sos) to the vehicle driving control system (S_{DC}),
wherein the vehicle EMC measurement system (S_{EMC}) comprises an EMC test chamber (C), an electromagnetic radiation transmitting/receiving unit (U_{TR}), an external output unit (Uoε), and an EMC measuring unit (U_{EMC}), wherein the method comprises the steps:
providing the complete vehicle (V) and positioning the vehicle (V) in the EMC test chamber (C);
disconnecting the communication cables (2) from the ADAS sensors (1), preventing communication between the ADAS sensors (1) and the vehicle driving control system (S_{DC});
connecting the communication cables (2) to the external output unit (Uoε), enabling communication between the external output unit (Uoε) and the vehicle driving control system (S_{DC});
activating the vehicle driving control system (S_{DC}) for operating the vehicle (V) in the EMC test chamber (C), and transmitting synchronized external ADAS sensor output signals (Sosε) from the external output unit (Uoε) to the vehicle driving control system (S_{DC}) via the communication cables (2);
transmitting electromagnetic radiation in the EMC test chamber (C) by means of the electromagnetic radiation transmitting/receiving unit (U_{TR}), and conducting EMC immunity measurements of the vehicle (V) by means of the EMC measuring unit (U_{EMC}) upon activation of the vehicle driving control system (S_{DC}) for operating the vehicle (V) when the synchronized external ADAS sensor output signals (Sosε) are transmitted to the vehicle driving control system (S_{DC}) from the external output unit (Uoε), or
receiving electromagnetic radiation from the vehicle (V) in the EMC test chamber (C) by means of the electromagnetic radiation transmitting/receiving unit (U_{TR}), and conducting EMC radiation measurements of the vehicle (V) by means of the EMC measuring unit (U_{EMC}) upon activation of the vehicle driving control system (S_{DC}) for operating the vehicle (V) when the synchronized external ADAS sensor output signals (Sosε) are transmitted to the vehicle driving control system (S_{DC}) from the external output unit (U_{OE}).

2. The method according to claim 1,
wherein the synchronized external ADAS sensor output signals (S_{OSE}) transmitted from the external output unit (Uoε) are corresponding to ADAS sensor output signals (Sos) transmitted from the ADAS sensors (1) to the vehicle driving control system (S_{DC}) upon operating the vehicle (V) in real traffic situations.

3. The method according to claim 1 or 2,
wherein the synchronized external ADAS sensor output signals (Sosε) are recorded synchronized ADAS sensor output signals (Sos) from real traffic situations, and/or wherein the synchronized external ADAS sensor output signals (Sosε) are simulated synchronized ADAS sensor output signals (Sos) corresponding to real traffic situations.

4. The method according to any preceding claim,
wherein the method further comprises the steps: operating the vehicle (V) in an autonomous driving mode (M_{AU}) or operating the vehicle (V) in a semi-autonomous driving mode (M_{SA}), upon activation of the vehicle driving control system (S_{DC}).

5. The method according to any preceding claim,
wherein the external output unit (U_{OE}) is arranged in a position outside the EMC test chamber (C), wherein external communication cables (3) connected to the external output unit (U_{OE}) are extending from the external output unit (U_{OE}) to the vehicle (V), wherein the method further comprises the step: connecting the external output unit (Uoε) to the communication cables (2) of the vehicle (V) via the external communication cables (3) for enabling communication between the external output unit (Uoε) and the vehicle driving control system (S_{DC}).

6. The method according to any preceding claim,
wherein the external communication cables (3) are arranged as fibre optic links.

7. The method according to any preceding claim,
wherein the EMC test chamber (C) is configured as an electromagnetic reverberation chamber or an electromagnetic anechoing chamber.

8. The method according to any preceding claim,
wherein the steps of: activating the vehicle driving control system (S_{DC}), and transmitting synchronized external ADAS sensor output signals (Sosε) from the external output unit (Uoε) to the vehicle driving control system (S_{DC}) via the communication cables (2); and transmitting electromagnetic radiation in the EMC test chamber (C) by means of the electromagnetic radiation transmitting/receiving unit (U_{TR}), and conducting EMC immunity measurements of the vehicle (V) by means of the EMC measuring unit (U_{EMC}) upon activation of the vehicle driving control system (S_{DC}) for operating the vehicle (V) when the synchronized external ADAS sensor output signals (S_{OSE}) are transmitted to the vehicle driving control system (S_{DC}) from the external output unit (U_{OE}); are computer implemented, or
wherein the steps of: activating the vehicle driving control system (S_{DC}), and transmitting synchronized external ADAS sensor output signals (S_{OSE}) from the external output unit (Uoε) to the vehicle driving control system (S_{DC}) via the communication cables (2); and receiving electromagnetic radiation from the vehicle (V) in the EMC test chamber (C) by means of the electromagnetic radiation transmitting/receiving unit (U_{TR}), and conducting EMC radiation measurements of the vehicle (V) by means of the EMC measuring unit (U_{EMC}) upon activation of the vehicle driving control system (S_{DC}) for operating the vehicle (V) when the synchronized external ADAS sensor output signals (Sosε) are transmitted to the vehicle driving control system (S_{DC}) from the external output unit (Uoε); are computer implemented.

9. A vehicle EMC measurement system (S_{EMC}) comprising an EMC test chamber (C), an electromagnetic radiation transmitting/receiving unit (U_{TR}), an external output unit (Uoε), and an EMC measuring unit (U_{EMC}),
wherein the vehicle EMC measurement system (S_{EMC}) is arranged for measuring EMC of a complete vehicle (V) positioned in the EMC test chamber (C),
wherein the vehicle (V) comprises ADAS sensors (1) and a vehicle driving control system (S_{DC}) configured for controlling operation of the vehicle (V), wherein the ADAS sensors (1) are connected to and in communication with the vehicle driving control system (S_{DC}) via communication cables (2) and configured for sending ADAS sensor output signals (Sos) to the vehicle driving control system (S_{DC}),
wherein the external output unit (Uoε) is configured for being connected to the vehicle driving control system (S_{DC}) via the communication cables (2), enabling communication between the external output unit (Uoε) and the vehicle driving control system (S_{DC}), when the communication cables (2) are disconnected from the ADAS sensors (1), preventing communication between the ADAS sensors (1) and the vehicle driving control system (S_{DC}),
wherein the external output unit (Uoε) is configured for transmitting synchronized external ADAS sensor output signals (Sosε) to the vehicle driving control system (S_{DC}) via the communication cables (2) upon activation of the vehicle driving control system (S_{DC}) for operating the vehicle (V) in the EMC test chamber (C),
wherein the electromagnetic radiation transmitting/receiving unit (U_{TR}) is configured for transmitting electromagnetic radiation in the EMC test chamber (C), and the EMC measuring unit (U_{EMC}) is configured for conducting EMC immunity measurements of the vehicle (V) upon activation of the vehicle driving control system (S_{DC}) for operating the vehicle (V) when the synchronized external ADAS sensor output signals (S_{OSE}) are transmitted to the vehicle driving control system (S_{DC}) from the external output unit (U_{OE}), or
wherein the electromagnetic radiation transmitting/receiving unit (U_{TR}) is configured for receiving electromagnetic radiation from the vehicle (V) in the EMC test chamber (C), and the EMC measuring unit (U_{EMC}) is configured for conducting EMC radiation measurements of the vehicle (V) upon activation of the vehicle driving control system (S_{DC}) for operating the vehicle (V) when the synchronized external ADAS sensor output signals (Sosε) are transmitted to the vehicle driving control system (S_{DC}) from the external output unit (Uoε).

10. The vehicle EMC measurement system (S_{EMC}) according to claim 9,
wherein the synchronized external ADAS sensor output signals (Sosε) transmitted from the external output unit (Uoε) are corresponding to ADAS sensor output signals (S_{OS}) transmitted from the ADAS sensors (1) to the vehicle driving control system (S_{DC}) upon operating the vehicle (V) in real traffic situations.

11. The vehicle EMC measurement system (S_{EMC}) according to claim 9 or 10,
wherein the synchronized external ADAS sensor output signals (S_{OSE}) are recorded synchronized ADAS sensor output signals (S_{OS}) from real traffic situations, and/or wherein the synchronized external ADAS sensor output signals (Sosε) are simulated synchronized ADAS sensor output signals (S_{OS}) corresponding to real traffic situations.

12. The vehicle EMC measurement system (S_{EMC}) according to any of claims 9 to 11,
wherein the vehicle (V) is operated in an autonomous driving mode (M_{AU}) or in a semi-autonomous driving mode (M_{SA}), upon activation of the vehicle driving control system (S_{DC}).

13. The vehicle EMC measurement system (S_{EMC}) according to any of claims 9 to 12,
wherein the external output unit (Uoε) is arranged in a position outside the EMC test chamber (C), wherein external communication cables (3) connected to the external output unit (U_{OE}) are extending from the external output unit (U_{OE}) to the vehicle (V), wherein the external output unit (Uoε) is connected to the communication cables (2) of the vehicle (V) via the external communication cables (3), enabling communication between the external output unit (Uoε) and the vehicle driving control system (S_{DC}).

14. The vehicle EMC measurement system (S_{EMC}) according to any of claims 9 to 13,
wherein the external communication cables (3) are arranged as fibre optic links.

15. The vehicle EMC measurement system (S_{EMC}) according to any of claims 9 to 14,
wherein the EMC test chamber (C) is configured as an electromagnetic reverberation chamber or an electromagnetic anechoing chamber.

16. The vehicle EMC measurement system (S_{EMC}) according to any of claims 9 to 15,
wherein the electromagnetic radiation transmitting/receiving unit (U_{TR}) comprises one or more antennas (7) arranged in the EMC test chamber (C), wherein the one or more antennas (7) are configured for transmitting and/or receiving electromagnetic radiation in the EMC test chamber (C).

17. A non-transitory computer-readable medium comprising instructions which, when executed by a computer, cause the computer to carry out the method of claim 8.

18. A cloud computing system configured to carry out the method of claim 8.
